# EUROPÄISCHE PATENTANMELDUNG

(11) **EP 0 886 185 A2**
(43) Veröffentlichungstag der Anmeldung: **23.12.1998**
(21) Anmeldenummer: 98109121.8
(22) Anmeldetag: 19.05.1998
(51) Int. Cl.: G03F 7/40, G03C 9/00, G03H 1/00

(54) **Verfahren zur Herstellung eines Prägezylinders**

(30) Priorität: 22.05.1997 DE 19721524
(71) Anmelder: HSM Holographic Systems München GmbH, 85652 Ottersberg (DE)
(72) Erfinder: Dausmann, Günther, 85435 Erding (DE); Menz, Irina, Dr., 86420 Diedorf (DE)
(74) Vertreter: Zinnecker, Armin, Dipl.-Ing.

(57) **Zusammenfassung**

Bei einem Verfahren zur Herstellung eines Prägezylinders wird die Mantelfläche eines Zylinderkörpers mit Fotoresist beschichtet. Die Fotoresist beschichtete Mantelfläche wir zur Erzeugung eines Bildes auf dem Fotoresist belichtet. Das auf dem Fotoresist erzeugte Bild wird zur Erzeugung einer reliefartigen Oberflächenstruktur entwickelt. Um eine längere Haltbarkeit des Prägezylinders zu erreichen, wird der Fotoresist nach der Entwicklung einer Behandlung mit siliziumorganischen Verbindungen bei gleichzeitiger Temperung und UV-Bestrahlung unterzogen.

## Beschreibung

Die vorliegende Erfindung betrifft ein Verfahren zum Herstellen eines Prägezylinders.

In der Prägetechnologie zur Herstellung von Diffraktions- und Hologrammfolien ist es bekannt, Nickelprägematritzen, die über mehrmalige galvanische Abformungsschritte von einem fotolitografisch erzeugtem Fotoresistoberflächenrelief erhalten sind, auf glatt polierte, staubfreie Prägewalzen zu montieren. Staubteilchen zwischen Walze und Nickelmatrize sowie die hohen Arbeitstemperaturen und -drücke beim Herstellen der Nickelmatrize und beim Prägen führen zu einem schnellen Verschleiß der Matrizen. Für Prägungen von Folien mit einer Breite von über 30 cm ergeben sich ferner Probleme hinsichtlich der Prägetiefenhomogenität über die gesamte Folienbreite infolge auftretender Temperatur- und Druckgradienten.

Zu diesem Problem wurde beispielsweise in der US 4,906,315 bzw. der US 4,758,296 vorgeschlagen, hochviskose UV-härtbare Lacke zu verwenden, in welche die Reliefstrukturen der Nickelprägematritzen oder anderer Prägematrizen, beispielsweise Kunststoffprägematrizen, eingeprägt werden. Diese Verfahren werden als "Kaltprägungsverfahren" bzw. "Wet-Embossing-Verfahren" bezeichnet. Durch Auflaminierung auf einen Trägerfilm werden die eingeprägten Lacke von der Matrize abgelöst und durch den Trägerfilm hindurch mit UV-Licht oder Elektronenstrahlen gehärtet. Die UV-Härtung ist umso aufwendiger, je lichtundurchlässiger die Trägerschicht ist. Bei Verwendung von Papier als Trägerschicht bzw. Trägermaterial ist eine Härtung nur mittels der aufwendigen und kostenungünstigen Elektronenstrahlhärtung möglich.

Zur Umgehung dieser Schwierigkeiten wird in der DE 41 32 476 A1 die Verwendung und Herstellung eines transparenten Prägezylinders vorgeschlagen, der die UV-Härtung vom Innenraum des Zylinders heraus während des Abformungsprozesses ermöglicht. Der Zylinder besteht aus Quarz, auf dessen Außenoberfläche sich eine UV-gehärtete Lackschicht mit der Oberflächenreliefstruktur bzw. dem Image-Relief befindet. Zur Erzeugung dieses Reliefs bzw. zu seiner Aufbringung auf den Zylinder werden mehrere komplizierte Abformschritte, ausgehend von einer von der Fotoresistoberflächenreliefstruktur galvanisch abgeformten Nickelmatrix beschrieben. Diese Nickelmatrix wird wiederum in eine flexible Acrylfolie abgeformt, welche als negativ in die Innenseite eines Zylinders gebracht wird. In das Innere dieses Zylinders wird der Quarzzylinder eingeführt und der Zwischenraum mit UV-härtbarem Lack gefüllt. Durch eine UV-Härtung dieses in den Zwischenraum eingefüllten Lacks wird dann die Reliefstruktur auf die Mantelfläche des Quarzzylinders abgeformt. Anschließend wird der äußere Zylinder zusammen mit der flexiblen Acrylfolie entfernt.

Abgesehen davon, daß dieses Verfahren sehr aufwendig ist, bereitet das Ablösen der flexiblen Negativfolie bei der Herstellung des Außenreliefs des Zylinders Schwierigkeiten, da die für dieses Verfahren verwendeten UV-härtbaren Materialien aus chemischen Grundbausteinen derselben Verbindungsklasse bestehen (Resiste auf Acrylatbasis).

Da bekannte Verfahren von planen Matrizen ausgehen, die als Negativ auf einen Herstellungszylinder aufgebracht werden müssen, entsteht an der Stoßstelle der Enden der Matrizen eine mehr oder weniger ausgeprägte "Naht". Derartige Nähte sind bei den hergestellten Diffraktionsfolien, insbesondere bei Folien mit Endlosmuster, im Abstand der Matrizenlänge als Musterunterbrechungen erkennbar, die zur Beeinträchtigung der optischen Qualität führen.

Aufgabe der Erfindung ist es daher, ein Verfahren anzugeben, mit welchem eine längere Haltbarkeit eines Prägezylinders zum Prägen von diffraktiv-optischen Folien möglich ist.

Erfindungsgemäß wird diese Aufgabe gelöst durch ein Verfahren mit den Merkmalen des Patentanspruchs 1.

Erfindungsgemäß ist nun ein Verfahren geschaffen, mit dem die Herstellung eines eine Oberflächenreliefstruktur aufweisenden Prägeylinders gegenüber herkömmlichen Verfahren vereinfacht ist. Insbesondere sind nun keine galvanischen Abformprozesse mehr notwendig. Es ist nun möglich, Endlos-Diffraktionsmusterfolien ohne erkennbare Musterunterbrechung herzustellen. Der erfindungsgemäß hergestellte Prägezylinder weist eine gegenüber Temperaturbelastungen und chemischen Einflüssen sehr formbeständige Oberflächenstrukturierung auf, so daß der Prägezylinder ohne Verschleißerscheinungen zur Herstellung von Prägefolien eingesetzt werden kann. Mit dem erfindungsgemäß hergestellten Prägezylinder ist es erstmals möglich, diffraktiv-optische Folien als Endlosmuster, d. h. ohne Nähte, die zu einer Beeinträchtigung der optischen Qualität führen, herzustellen.

Vorteilhafte Weiterbildungen des erfindungsgemäßen Verfahrens sind Gegenstand der Unteransprüche.

Nach einer bevorzugten Ausgestaltung des Verfahrens wird durch die Belichtung auf dem Fotoresist ein ein Hologramm darstellendes Interferenzmuster erzeugt. Hierdurch ist ein Verfahren geschaffen, mit dem Hologramme in einfacher Weise in Prägefolien, in welche die Oberflächenreliefstruktur des Zylinders eingeprägt wird, eingebracht bzw. vervielfältigt werden könnten.

Die Belichtung kann mittels beliebiger Belichtungsverfahren, welche zur Herstellung von Hologramm-Interferenzstrukturen verwendbar sind, hergestellt werden. Insbesondere bevorzugt ist, daß die Belichtung mittels eines rechnergesteuerten Scanning-Verfahrens durchgeführt wird. Hierbei können beispielsweise in einem Rechner gespeicherte Bilder auf ein LCD-Element ausgelesen werden, welches dann von einer Objektstrahlenquelle beleuchtet und mit einer Referenzstrahlenquelle zur Erzeugung einer Hologrammstruktur auf dem Fotoresist zur Interferenz gebracht wird. Derartige Belichtungsverfahren sind in der DE 195 23 321 A1 beschrieben. Sämtliche dort beschriebenen Belichtungsverfahren können beim erfindungsgemäßen Verfahren vorteilhaft verwendet werden.

Besonders bevorzugt ist, daß ein Bild eines Objektes zeilenweise von einem das Bild speichernden Rechner abgerufen wird, zur Erzeugung der Bildpunkte jeder Zeile der Rechner einen im Strahlengang eines Laserstrahls angeordneten Verschluß oder eine Blende steuert und der durch den Verschluß oder die Blende durchtretende und in seiner Helligkeit gesteuerte Strahl von einem Spiegel einer Ablenkeinheit zeilenweise auf die Fotoresistschicht zur Erzeugung eines Bildes reflektiert und hierbei mit einem Referenzstrahl zur Interferenz gebracht wird. Durch diese zeilenweise Belichtung ist es möglich, durch die Krümmung der Zylinderoberfläche hervorgerufene Effekte zu kompensieren. Es ist insbesondere möglich, einen Spiegel in die Mitte des Zylinders einzubringen und über diesen den Referenzstrahl und/oder den Objektstrahl auf die Fotoresistschicht abzubilden. Bei der Herstellung eines Prägezylinders wird jedoch bevorzugt, sowohl den Objektstrahl als auch den Referenzstrahl von außen auf die Zylinderoberfläche einzustrahlen.

Eine weitere vorteilhafte Weiterbildung ist dadurch gekennzeichnet, daß ein Bild eines Objektes in einer spiralförmigen Endloslinie von einem das Bild speichernden Rechner abgerufen wird und daß zur Erzeugung der Bildpunkte der spiralförmigen Endloslinie der Rechner einen im Strahlengang eines Laserstrahls angeordneten Zylinder in Rotation und Vorschub derart steuert, daß die spiralförmige Endloslinie auf die Zylinderoberfläche aufbelichtet wird und hierbei mit einem Referenzstrahl zur Inferferenz gebracht wird.

Durch die Entwicklung des belichteten Fotoresists lassen sich in einfacher Weise Phasenhologramme herstellen.

Zweckmäßigerweise erfolgt die Entwicklung des Fotoresists in einem nassalkalischen bzw. wässrigalkalischen Entwickler.

Besonders bevorzugt ist, daß die durch die Entwicklung erzeugte oberflächenstrukturierte Fotoresistschicht einer Behandlung mit siliziumorganischen Verbindungen bei gleichzeitiger Temperung und UV-Bestrahlung unterzogen wird. Durch diese Behandlung ist es möglich, eine gegenüber Temperaturbelastungen und chemischen Einflüssen sehr formbeständige Oberflächenstrukturierung zu erhalten, so daß der Prägezylinder ohne Verschleißerscheinungen zur Herstellung von Prägefolien eingesetzt werden kann.

Besonders bevorzugt ist, daß die Behandlung derart durchgeführt wird, daß die ein Hologramm darstellende Fotoresistschicht eine Formstabilität bis zu etwa 170° C aufweist. Die hierzu notwendige Behandlung ist mit relativ geringem Aufwand durchzuführen (relativ geringe Behandlungsdauer), wobei eine Formstabilität bis 170° C für einen breiten Bereich von Anwendungen ausreichend ist.

Besonders bevorzugt ist, daß als siliziumorganische Verbindung Hexamethyldisiloxan und/oder Fluoralkyloxysilane verwendet wird. Mit dieser Verbindung sind bei gleichzeitiger Temperung und UV-Bestrahlung sehr gute Härtungsergebnisse erzielbar.

Besonders bevorzugt ist eine UV-Flutbelichtung der Resistoberfläche unter Einwirkung der siliziumorganischen Verbindungen bei Temperaturen zwischen 100° C und 160° C. Derartige Temperaturen sind leicht zur Verfügung zu stellen und führen zu ausreichenden Härten bzw. chemischer Resistenz der oberflächenstrukturierten Fotoresistschicht.

Besonders bevorzugt ist ferner, daß die Temperatur während der Temperung kontinuierlich erhöht wird. Vorzugsweise wird die Temperatur kontinuierlich bis auf 160° C erhöht. Durch eine derartige Temperaturerhöhung kann der Härtungsvorgang in optimaler Weise an die während des Aushärtungsvorgangs stetig anwachsende Härte des Fotoresists angepaßt werden. Würde man die Temperung bei einer zu hohen Temperatur beginnen, würde dies zu einem Zerfließen bzw. einer Beeinträchtigung der Oberflächenreliefstruktur führen. Durch das kontinuierliche Herauffahren der Temperatur wird dies vermieden, wobei die höheren Temperaturen gegen Ende des Aushärtungsvorgangs eine sehr große Härte bzw. chemische Widerstandsfähigkeit des derart behandelten Fotoresists gewährleisten.

Besonders bevorzugt ist, daß die siliziumorganischen Verbindungen dampfförmig oder flüssig auf die Fotoresistoberfläche einwirken. Hierdurch ist eine sehr gleichmäßige Verteilung bzw. ein gleichmäßiges Einwirken der siliziumorganischen Verbindungen auf den Fotoresist gewährleistet.

Bevorzugt ist, daß der Zylinderkörper als UV-durchlässiger Hohlzylinder ausgebildet ist und/oder daß der Fotoresist nach seiner Entwicklung und Härtung UV-durchlässig ist. Ein derartiger Prägezylinder gestattet die UV-Härtung einer Folie, in die die Oberflächenreliefstruktur des Zylinders eingeprägt wird, von der Zylinderinnenseite her. Hierdurch ist es möglich, einen auf einem undurchlässigen Substrat (beispielsweise Pappe, Papier) aufgebrachten UV-härtbaren Lack von der Innenseite des Prägezylinders her auszuhärten.

Besonders bevorzugt ist die Verwendung eines Fotoresists auf Naphtochinodiazid- bzw. Novolak-Basis. Dieses Material weist nach der beschriebenen Behandlung eine ausreichende Temperatur- und chemische Widerstandsfähigkeit auf.

Vorteilhafterweise besteht der Zylinderkörper aus glas- oder quarzartigem Material. Derartige Materialien sind sehr hart und formbeständig und weisen ferner eine gute UV-Durchlässigkeit auf.

Der transparente Prägezylinder weist eine gegenüber organischen Materialien, wie z. B. Kethonen, Esthern, Äthern, Alkoholen, sowie gegenüber hohen Temperaturen bis zu etwa 170° C bis 180° C hohe Resistenz und Formstabilität auf. Der erfindungsgemäße nahtlose Zylinder kann entweder direkt als Prägematrix zur Herstellung von Diffraktionsfolien ohne Naht im Wet-Embossing-Verfahren eingesetzt werden, oder aber zur Herstellung weiterer nahtloser Prägezylinder-Generationen im Rotativverfahren verwendet werden. Beispielsweise ist es möglich, für derartige weitere Prägezylinder andere, insbesondere UV-härtbare, transparente Kunststoffe zu verwenden.

Besonders bevorzugt ist schließlich die Verwendung eines erfindungsgemäß hergestellten Prägezylinders zum Prägen von diffraktischen Reliefstrukturen ohne Naht in Folien. Derartige Folien können nun erstmals ohne eine bei der herkömmlichen Herstellung von diffraktiv-optischen Folien auftretende Naht hergestellt werden, wodurch die optische Qualität der Folien verbessert ist.

Eine bevorzugte Ausführungsform der Erfindung wird nun im Einzelnen beschrieben.

Es zeigt
- Fig. 1: schematisch eine Belichtungsanordnung zur zeilenweisen Belichtung einer lichtempfindlichen Photoresistschicht, und
- Fig. 2: schematisch eine Belichtungsanordnung zur Belichtung einer Zylinderoberfläche von innen.

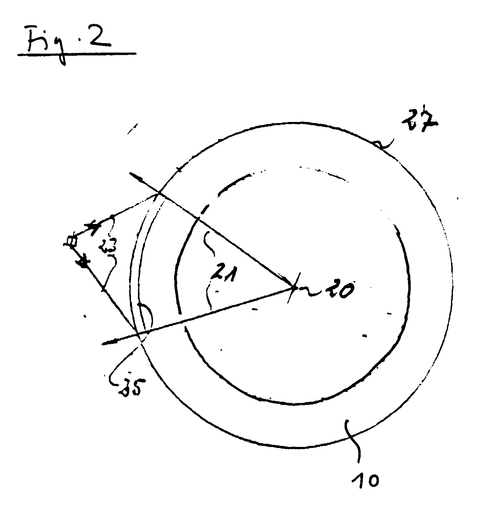

Ein UV-transparenter, hohl ausgebildeter Glaszylinder 10 (siehe Fig. 2) wird mit einem Fotoresist des Typs Naphtochinondiazid/Novolak derart tauch- oder sprühbeschichtet, daß auf der Zylinderaußenfläche eine Fotoresistschicht 27 einer Dicke von 1 bis 2, vorzugsweise 1,5 Mikrometer entsteht. Anschließend erfolgt eine Temperung in einem Konvektionsofen bei 90°C bis 100°C, vorzugsweise 95°C. Es ist ebenfalls möglich, die Temperung mittels einer IR-Trocknung durchzuführen.

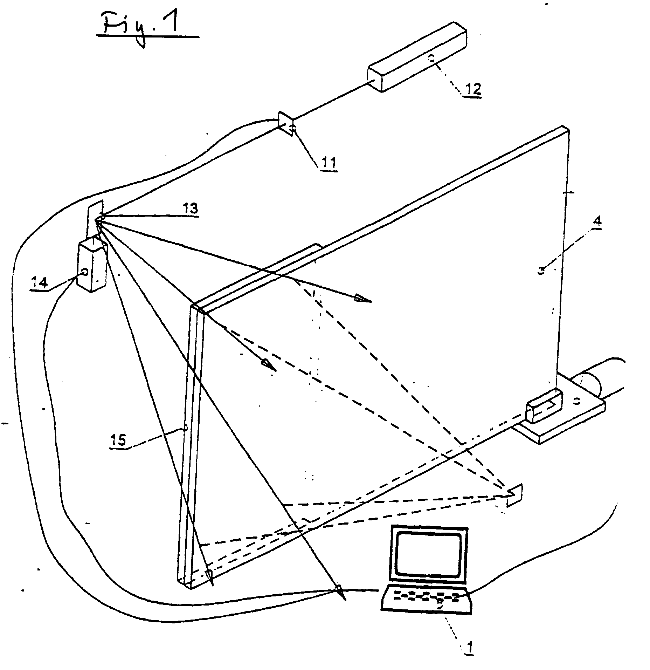

Die Belichtung der derart vorbereiteten Fotoresistschicht erfolgt im Scanningverfahren zur Erzeugung eines Hologramms. Eine Belichtungsanordnung zur Durchführung eines derartigen Scanningverfahrens ist in Fig. 1 dargestellt. Mit 4 ist hier die Lichtempfindliche Photoresistschicht bezeichnet. Da es sich um eine schematische Prinzipskizze handelt, ist die Photoresistschicht 4 nicht zylinderförmig, sondern eben dargestellt. Ein auf den Photoresist aufzuzeichnendes Bild eines Objektes ist in dem Rechner 1 gespeichert. Der Rechner 1 steuert zeilenweise den Verschluß bzw. die Blende 11, so daß Zeilen mit hellen, und in Graustufen bis zu dunklen Bildpunkten gebildet werden. Zur zeilenweisen Aufzeichnung dieser Bildpunkte trifft der entsprechend modulierte und von dem Laser 12 erzeugte Laserstrahl auf einen Spiegel 13 einer Ablenkeinheit 14, so daß die Ablenkeinheit zeilenweise nacheinander die Bilder auf die Photoresistschicht 4 projiziert. Unmittelbar vor der Photoresistschicht ist ein holographischer Strahlenteiler 15 angeordnet, der von dem Objektstrahl nullter Ordnung einen Referenzstrahl erster Ordnung abspaltet, der dann auf der Photoresistschicht 4 mit dem Objektstrahl interferiert. Es wäre auch möglich, einen Interferenzstrahl von einem zweiten Laser abzuleiten.

In Fig. 2 bildet ein Spiegel 20, der auf der Zylinderachse angeordnet ist, den Ursprung des Referenzstrahls. Der Referenzstrahl 21 beaufschlagt in der dargestellten Weise den holografischen Strahlteiler 25, der konzentrisch zu der holografischen Aufnahmeschicht bzw. Photoresistschicht 27 zylindrisch gekrümmt ist. Der Strahlteiler 25 erstreckt sich hierbei über ein Segment der Photoresistschicht bzw. Aufnahmeschicht 27. Mittels des Strahlteilers 25 ist es möglich, in der beschriebenen Weise einen Objektstrahl vom Referenzstrahl abzuteilen. Objektstrahl und Referenzstrahl interferieren in der Photoresistschicht 27, so daß die in dem Referenzstrahl oder Objektstrahl enthaltene amplitudenmodulierte Information als Hologramm im Photoresist gespeichert wird.

Es ist gleichfalls möglich, die Photoresistschicht 27 von außen zu belichten, wie durch Strahl 23 dargestellt. Hierbei kann ein dem Strahlteiler 25 entsprechender Strahlteiler außerhalb des Zylinders angeordnet werden.

Durch anschließende naßalkalische Entwicklung wird im Fotoresist 27 ein Oberflächenrelief erzeugt. Dieses Oberflächenrelief wird mittels einer UV-Flutbelichtung der Resistoberfläche bei gleichzeitiger Einwirkung von siliziumorganischen Verbindungen bei Temperaturen zwischen 100°C und 160°C ausgehärtet. Der derart hergestellte Zylinder kann als Prägezylinder zur Einprägung seiner Oberflächenreliefstruktur in UV-härtbare Lacke während des rotativen Abformprozesses zur Herstellung von geprägten Folien verwendet werden. Es ist ferner möglich, weitere Prägezylindergenerationen im Rotativverfahren herzustellen. Durch diese rotative Abformung ist es möglich, für die nachfolgenden Zylindergenerationen beliebige, insbesondere transparente Materialien zu wählen, so daß eventuelle Ablöseprobleme bei der Herstellung von Prägefolien aus UV-härtbaren Lacken wirksam vermieden werden können. Es ist ebenfalls möglich, als Material für die mittels Rotativverfahren zu prägende Oberfläche eines Zylinders einer nachfolgenden Generation einen UV-härtbaren Lack zu verwenden.

## Patentansprüche

1. Verfahren zur Herstellung eines Prägezylinders, bei dem die Mantelfläche eines Zylinderkörpers mit Fotoresist beschichtet wird, die mit Fotoresist beschichtete Mantelfläche zur Erzeugung eines Bildes auf dem Fotoresist belichtet wird und das auf dem Fotoresist erzeugte Bild zur Erzeugung einer reliefartigen Oberflächenstruktur entwickelt wird,
dadurch gekennzeichnet,
daß der Fotoresist nach der Entwicklung einer Behandlung mit siliziumorganischen Verbindungen bei gleichzeitiger Temperung und UV-Bestrahlung unterzogen wird.

2. Verfahren nach Anspruch 1, dadurch gekennzeichnet, daß die Belichtung mittels eines rechnergesteuerten Scanning-Verfahrens durchgeführt wird.

3. Verfahren nach Anspruch 2, dadurch gekennzeichnet, daß ein Bild eines Objektes zeilenweise von einem das Bild speichernden Rechner abgerufen wird, zur Erzeugung der Bildpunkte jeder Zeile der Rechner einen im Strahlengang eines Laserstahls angeordneten Verschluß oder eine Blende steuert, der durch den Verschluß oder die Blende durchtretende und in seiner Helligkeit gesteuerte Strahl von einem Spiegel einer Ablenkeinheit zeilenweise auf den zu belichtenden Fotoresist zur Erzeugung eines Bildes reflektiert und hierbei mit einem Referenzstrahl zur Interferenz gebracht wird.

4. Verfahren nach Anspruch 2, dadurch gekennzeichnet, daß ein Bild eines Objekts in einer spiralförmigen Endloslinie von einem das Bild speichernden Rechner abgerufen wird und daß zur Erzeugung der Bildpunkte der spiralförmigen Endloslinie der Rechner einen im Strahlengang eines Laserstrahls angeordneten Zylinder in Rotation und Vorschub derart steuert, daß die spiralförmige Endloslinie auf die Zylinderoberfläche aufbelichtet wird und hierbei mit einem Referenzstrahl zur Interferenz gebracht wird.

5. Verfahren nach einem der vorhergehenden Ansprüche, gekennzeichnet durch eine Behandlung der entwickelten, oberflächenstrukturierten Fotoresistschicht mit siliziumorganischen Verbindungen bei gleichzeitiger Temperung und UV-Bestrahlung.

6. Verfahren nach Anspruch 5, dadurch gekennzeichnet, daß die Behandlung derart durchgeführt wird, daß die oberflächenstrukturierte Fotoresistschicht eine Formstabilität bis zu etwa 170° C aufweist.

7. Verfahren nach einem der vorhergehenden Ansprüche, dadurch gekennzeichnet, daß als siliziumorganische Verbindungen Hexamethyldisiloxan und/oder Fluoralkyloxysilane verwendet werden.

8. Verfahren nach einem der vorstehenden Ansprüche, dadurch gekennzeichnet, daß die Temperatur während der Temperung kontinuierlich bis auf 160° C erhöht wird.

9. Verfahren nach einem der vorstehenden Ansprüche, dadurch gekennzeichnet, daß die siliziumorganischen Verbindungen dampfförmig oder flüssig auf die Fotoresistoberfläche einwirken.

10. Verfahren nach einem der vorstehenden Ansprüche, dadurch gekennzeichnet, daß der Zylinderkörper als UV-durchlässiger Hohlzylinder ausgebildet ist und/oder daß der Photoresist nach seiner Entwicklung und Härtung UV-durchlässig ist.

11. Verfahren nach einem der vorstehenden Ansprüche, dadurch gekennzeichnet, daß der Fotoresist vom Typ Naphtochinodiazid/Novolak ist.

12. Verfahren nach einem der vorstehenden Ansprüche, dadurch gekennzeichnet, daß der Zylinder aus glasartigem oder quarzartigem Material hergestellt ist.

13. Verwendung eines Prägezylinders nach einem der vorstehenden Ansprüche zum Prägen von diffraktischen Reliefstrukturen ohne Naht in Folien.
